(19) Europäisches Patentamt
European Patent Office
Office européen des brevets

(11) **EP 2 745 007 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**05.10.2022 Patentblatt 2022/40**

(45) Hinweis auf die Patenterteilung:
**13.03.2019 Patentblatt 2019/11**

(21) Anmeldenummer: **12758399.5**

(22) Anmeldetag: **13.08.2012**

(51) Internationale Patentklassifikation (IPC):
**G01R 21/133** (2006.01)   **G01M 15/00** (2006.01)
**F03D 17/00** (2016.01)   **F03D 7/04** (2006.01)

(52) Gemeinsame Patentklassifikation (CPC):
**F03D 7/048; F03D 17/00;** F05B 2270/20;
F05B 2270/204; Y02E 10/72

(86) Internationale Anmeldenummer:
**PCT/EP2012/003447**

(87) Internationale Veröffentlichungsnummer:
**WO 2013/026538 (28.02.2013 Gazette 2013/09)**

(54) **ENERGIEERTRAGSVERLUSTBESTIMMUNG EINER WINDENERGIEANLAGE**

DETERMINING THE ENERGY YIELD LOSS OF A WIND TURBINE

DÉTERMINATION DE LA PERTE DE RENDEMENT ÉNERGÉTIQUE D'UNE ÉOLIENNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.08.2011 DE 102011081241**

(43) Veröffentlichungstag der Anmeldung:
**25.06.2014 Patentblatt 2014/26**

(73) Patentinhaber: **Siemens Gamesa Renewable Energy Service GmbH
20097 Hamburg (DE)**

(72) Erfinder:
• **MITTELMEIER, Niko**
**22303 Hamburg (DE)**
• **BERGMANN, Matthias**
**22307 Hamburg (DE)**
• **BLODAU, Tomas**
**10119 Berlin (DE)**
• **SCHUBERT, Alexander**
**24145 Kiel (DE)**

(74) Vertreter: **Wallinger Ricker Schlotter Tostmann
Patent- und Rechtsanwälte mbB
Zweibrückenstraße 5-7
80331 München (DE)**

(56) Entgegenhaltungen:
EP-A1- 1 944 509       EP-A2- 2 028 368
EP-B1- 2 673 503       DE-A1-102004 056 254
DE-A1-102004 057 320   DE-A1-102007 036 447
US-A1- 2010 115 951

• ALBERS, A.: "Efficient Wind Farm Performance Analysis", DEWEK, 2004,
• Vollständiges Dokument mit Deckblatt zu E5

**EP 2 745 007 B2**

**Beschreibung**

Die Erfindung betrifft ein Verfahren zur Ermittlung eines Energieertragsverlustes einer ersten Windenergieanlage aus einem Windenergieanlagenpark mit mehreren Windenergieanlagen.

Besonders bei großen Windenergieanlagenparks ist es gewünscht, einem Kunden anstelle einer Verfügbarkeitsgarantie der Windenergieanlagen eine Energieertragsgarantie anzubieten. Hierbei ist es allerdings schwierig, bei Ausfall einer Windenergieanlage bzw. einer nur reduzierten Leistungsausbeute einer Windenergieanlage, d.h. einer Windenergieanlage, die in einem reduzierten Energieertragsbetrieb geführt wird, den verlorenen Energieertrag zu quantifizieren. Der verlorene Energieertrag ist hierbei die Differenz zwischen dem tatsächlich möglichen Energieertrag bei einem energieoptimierten Normalbetrieb und dem tatsächlichen Energieertrag einer Windenergieanlage, die in einem reduzierten Energieertragsbetrieb gefahren wird oder sogar ausfällt bzw. ohne Energieertrag gefahren wird. Es ist allerdings schwierig, den tatsächlichen Energieertrag, der im energieoptimierten Normalbetrieb möglich wäre, zu bestimmen. Hierzu müsste ein genaues Windstärkenprofil orts- und zeitaufgelöst an der Windenergieanlage, die im reduzierten Energieertragsbetrieb geführt wird, erstellt werden, was exakt unmöglich ist und angenähert mit bekannten Methoden, wie beispielsweise einem Gondelanemometer oder mehreren Gondelanemometern im Bereich der Windenergieanlage nur sehr ungenau möglich ist.

Bei einem vorhandenen Windmessmast in der Nähe der Windenergieanlage oder des Windparks könnte anhand einer vorliegenden Windenergieanlagenleistungskurve der Energieertrag unter der Annahme, dass der Wind in der Rotorebene dem Wind am Messmast entspricht, errechnet werden. Dieses Verfahren ist allerdings aufgrund der Annahme, die der Wirklichkeit nicht entspricht, und zwar insbesondere in Windparks, auch zu ungenau. Zudem ist auch der Ansatz, das Gondelanemometer der im reduzierten Energieertragsbetrieb geführten Windenergieanlagen zu nutzen, zu ungenau, da die Anemometermessung durch die Gondel und gegebenenfalls auch die Rotorblätter von Windenergieanlagen, die in unmittelbarer Nähe vorhanden sind, stark verfälscht wird.

US 2010 0115951 A1 offenbart einen Windenergieanlagenpark, bei dem mehrere Windenergieanlagen vorgesehen sind, die auf unterschiedliche Windgeschwindigkeitsbereiche optimiert sind.

EP 2 028 368 A2 offenbart einen Windpark mit einer Vielzahl von Windenergieanlagen sowie ein Verfahren zum Betreiben des Windparks, wobei eine übergeordnete Steuerung einen aktuell maximal zulässigen Wert für die elektrische Größe, die der Windenergiepark bereitstellen soll, berechnet oder empfängt und die übergeordnete Steuerung jeder Windenergieanlage einen Sollwert für die elektrische Größe übermittelt.

EP 1 944 509 A1 offenbart ein Frühwarnsystem für Windenergieanlagen mit SODAR.

Es ist Aufgabe der vorliegenden Erfindung, ein Verfahren zur Ermittlung eines Energieertragsverlustes einer ersten Windenergieanlage aus einem Windenergieanlagenpark mit mehreren Windenergieanlagen, wobei die erste Windenergieanlage in einem reduzierten Energieertragsbetrieb geführt wird, anzugeben, das eine genauere Bestimmung des Energieertragsverlustes ermöglicht.

Gelöst wird diese Aufgabe durch ein Verfahren gemäß Anspruch 1.

Der Energieertragsverlust der ersten Windenergieanlage ist dann die Differenz des Energieertragspotentials der ersten Windenergieanlage und des ermittelten reduzierten Energieertrags, also insbesondere des gemessenen Energieertrags der ersten Windenergieanlage. Unter einem energieoptimierten Normalbetrieb ist ein Betrieb einer Windenergieanlage zu verstehen, der darauf abzielt, eine optimale Energiemenge bzw. eine optimale Leistung der Windenergieanlage zu erzeugen. Dieses ist ab einer Nennwindgeschwindigkeit dann der Betrieb der Windenergieanlage bei Nennleistung und vor der Nennwindgeschwindigkeit üblicherweise ein Betrieb, bei dem der Energieertrag bzw. die erzeugte Leistung mit zunehmender Windstärke steigt. Bei Erreichen der Nennleistung ist dann ein Volllastbetrieb erreicht und vor Erreichen der Nennleistung bzw. der Nennwindgeschwindigkeit ein Teillastbetrieb, wobei der Teillastbetrieb auch einen energieoptimierten Normalbetrieb darstellt. Übliche Kennlinien sind beispielsweise im Bild 14.5 auf Seite 546 des Lehrbuchs von Erich Hau, 4. Auflage, mit dem Titel "Windkraftanlagen", Springer-Verlag, Berlin, Heidelberg, dargestellt.

Im Bild 14.5 auf Seite 546 des Lehrbuchs von Erich Hau sind mehrere Betriebskennlinien für den Teillast- und Volllastbetriebsbereich im Rotorleistungskennfeld einer Windenergieanlage dargestellt. Es ist der Rotorleistungsbeiwert über die Schnelllaufzahl aufgetragen. In dem Rotorleistungsbeiwert steckt die Leistung, die von der Windenergieanlage abgegeben wird und in der Schnelllaufzahl die Windgeschwindigkeit. In diesem Ausführungsbeispiel wird eine Betriebskennlinie abgefahren, bei der der Pitchwinkel der Rotorblätter der Windenergieanlage zunächst bei hoher Schnelllaufzahl, d.h. niedriger Windgeschwindigkeit, auf 5° eingestellt ist (vgl. die gestrichelte dick gezeichnete Linie). Ab einer gewissen Schnelllaufzahl von ca. 12,5 wird der Generator zugeschaltet, d.h. die Windenergieanlage befindet sich dann im Teillastbetrieb. Hierbei wird mit zunehmender Geschwindigkeit eine höhere Leistung produziert, wobei der Pitchwinkel bei 5° verbleibt. Ab dem Nennbetriebspunkt geht die Windenergieanlage in einen Volllastbetrieb, wobei bei zunehmender Windstärke der Pitchwinkel zu höheren Winkeln verstellt wird. Ab einer Abschaltwindgeschwindigkeit bei einem Pitchwinkel von ungefähr 27° wird die Windenergieanlage abgeschaltet. Es gibt auch Varianten, bei denen die Windenergieanlage bei einer Abschaltwindgeschwindigkeit noch nicht abgeschaltet wird, sondern zunächst in einer reduzierten Leistung mit einem höheren Rotorblatt- bzw. Pitchwinkel weiterbetrieben wird, um noch Leistung zu produzieren. Dieses kann auch einen energieoptimierten Normalbetrieb darstellen. Im Rahmen der Erfindung ist ein energieoptimierter Normalbetrieb somit der in Bild 14.5 der Seite 546 im Lehrbuch von Erich Hau dargestellte beispielhafte Verlauf. Ein reduzierter Energieertragsbetrieb ist ein Verlauf, der unterhalb dieser Kennlinie liegt, also weniger Energie bzw. Leistung produziert, und zwar typischerweise dadurch, dass ein höherer Blattwinkel bzw. Pitchwinkel eingestellt wird.

Gemäß einer Variante des Anspruchs 1 werden wenigstens zwei zweite Windenergieanlagen ausgewählt oder sind entsprechend ausgewählt, wobei der Energieertrag der wenigstens zwei zweiten Windenergieanlagen ermittelt wird, wobei in Abhängigkeit der Energieerträge der wenigstens zwei zweiten Windenergieanlagen ein Energieertragspotential der ersten Windenergieanlage bestimmt wird. Wenn das Verfahren entsprechend mit wenigstens zwei zweiten Windenergieanlagen erweitert wird, ist mit einem genaueren Ergebnis der Bestimmung des Energieertragspotentials der ersten Windenergieanlage zu rechnen.

Die wenigstens eine zweite Windenergieanlage oder die wenigstens zwei zweiten Windenergieanlagen wird oder werden erfindungsgemäß in einem energieoptimierten Normalbetrieb betrieben.

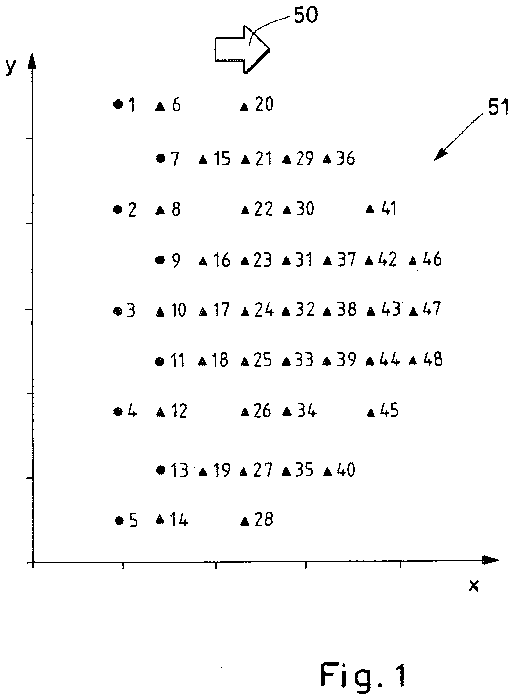

Entsprechend wird zusätzlich auf die EP 0 847 496 B1 verwiesen, in der in Fig. 1 Kennlinien dargestellt sind, die dazu dienen, der Betriebsführung vorzugeben, wie beispielsweise die Leistungskurve über die Windgeschwindigkeit zu fahren ist. Beim entsprechenden Fahren bzw. Betreiben der Windenergieanlage auf der Kennlinie der Leistung über der Windgeschwindigkeit, die in Fig. 1 dargestellt ist, handelt es sich auch um den energieoptimierten Normalbetrieb. Bei einem Betrieb der ersten Windenergieanlage, die einen reduzierten Energieertragsbetrieb aufweist, wäre ein Betrieb vorgesehen, der unterhalb der Kennlinie der Leistung über der Windgeschwindigkeit wäre. Insbesondere kann es hierbei auch vorzugsweise ein Stillstand oder ein leistungsloser Betrieb der ersten Windenergieanlage sein.

Besonders effizient ist das Verfahren dann, wenn gemäß einer Variante des Anspruchs 1 zur Bestimmung des Energieertragspotentials der ersten Windenergieanlage die Energieerträge der wenigstens zwei zweiten Windenergieanlagen interpoliert oder extrapoliert werden. Insbesondere beim Mitteln ergibt sich ein realistischer Wert für das Energieertragspotential der ersten Windenergieanlage. Hierbei kann insbesondere auch ein gewichteter Mittelwert verwendet werden, wenn beispielsweise aus insbesondere gespeicherten Erfahrungswerten bei bestimmten Umgebungsparametern, wie beispielsweise die Windrichtung und/oder die Windstärke, eine Dichtung der Energieerträge der jeweiligen zweiten Windenergieanlage bekannt ist, die zu einer genauen Angabe des Energieertragspotentials der ersten Windenergieanlage führt. Eine Dichtung kann vorzugsweise dann vorgenommen werden, wenn bekannt ist, dass bei einem vorbestimmten Umgebungsparameter eine zweite Windenergieanlage vom Energieertrag ähnlicher ist als eine weitere zweite Windenergieanlage. Besonders einfach kann eine Energieertragspotentialbestimmung durch Interpolation vorgenommen werden. Es kann auch Sinn machen, die entsprechenden Energieerträge der wenigstens zwei zweiten Windenergieanlagen zu extrapolieren, insbesondere dann, wenn für gewisse Umgebungsparameter bzw. bei wenigstens einem Umgebungsparameter ein Verhältnis der Energieerträge der wenigstens zwei zweiten Windenergieanlagen zur ersten Windenergieanlage bekannt sind bzw. ermittelt und/oder abgespeichert sind.

Besonders bevorzugt ist das Verfahren, wenn dieses automatisch, insbesondere vollautomatisch, durchgeführt wird. Unter vollautomatisch wird im Rahmen der Erfindung verstanden, dass das Verfahren vollautomatisch initiiert wird, sobald eine erste Windenergieanlage außerhalb eines energieoptimierten Normalbetriebs, d.h. in einem reduzierten Energieertragsbetrieb, geführt wird. Automatisch beinhaltet, dass das Verfahren nach Initiierung eines Operators automatisch durchgeführt wird.

Vorzugsweise ist das Führen der ersten Windenergieanlage in dem reduzierten Energieertragsbetrieb ein Stillstand oder ein leistungsloser Betrieb, beispielsweise ein Trudelbetrieb, der ersten Windenergieanlage.

Gemäß einer Variante des Anspruchs 1 wird oder ist der Windenergieanlagenpark in wenigstens eine erste und eine zweite Gruppe von Windenergieanlagen aufgeteilt, wobei die erste Windenergieanlage und die wenigstens eine zweite Windenergieanlage aus der gleichen Gruppe stammt oder die erste Windenergieanlage und die wenigstens zwei zweiten Windenergieanlagen aus der gleichen Gruppe stammen. In diesem Fall ist das Kriterium zur Auswahl der wenigstens zwei zweiten Windenergieanlagen dasjenige, dass die zweiten Windenergieanlagen zur Gruppe gehören, in der die erste Windenergieanlage ist.

Gemäß einer Variante des Anspruchs 1 umfasst die erste Gruppe von Windenergieanlagen frei vom Wind angeströmte Windenergieanlagen und die zweite Gruppe von Windenergieanlagen gestört vom Wind angeströmte Windenergieanlagen. Bei den gestört vom Wind angeströmten Windenergieanlagen handelt es sich um solche Windenergieanlagen, die von weiteren Windenergieanlagen im Hinblick auf die Anströmung des Windes gestört sind. Eine Störung entsteht beispielsweise durch eine Nachlaufströmung oder eine Wirbelschleppe von weiteren Windenergieanlagen. Frei angeströmte Windenergieanlagen sind beispielsweise diejenigen, die, ausgehend von einer vorgegebenen Windrichtung, die ersten Windenergieanlagen sind, die von dem Wind getroffen werden. Die dahinter angeordneten Windenergieanlagen sind dann typischerweise gestört vom Wind angeströmte Windenergieanlagen, da diese in der Wirbelzone der frei angeströmten Windenergieanlagen liegen.

Wenn die erste Windenergieanlage zur Gruppe der frei angeströmten Windenergieanlagen gehört, gehört die wenigstens eine zweite Windenergieanlage oder gehören die wenigstens zwei zweiten Windenergieanlagen dann auch zu dieser Gruppe. Andersherum gehören die zweiten Windenergieanlagen zur Gruppe der gestört vom Wind angeströmten Windenergieanlagen, wenn die erste Windenergieanlage auch zur Gruppe der gestört vom Wind angeströmten Windenergieanlagen gehört. In diesem Fall ist es besonders bevorzugt, wenn ein Mittelwert der Energieerträge der jeweiligen Gruppe von Windenergieanlagen gebildet wird und dieser Mittelwert der von den zweiten Windenergieanlagen aus dieser Gruppe von Windenergieanlagen als Energieertragspotential der ersten Windenergieanlage angesetzt wird. Welche Windenergieanlage in Abhängigkeit der Windrichtung zu den gestört vom Wind angeströmten und zu den ungestört vom Wind angeströmten bzw. frei vom Wind angeströmten Windenergieanlagen gehört, kann nach einer Formel berechnet werden, die im Rahmen der Figurenbeschreibungen im Folgenden angegeben wird. Bevorzugterweise werden alle zweiten Windenergieanlagen der entsprechenden Gruppe zur Bestimmung eines Mittelwertes der Energieerträge herangezogen, um so das Energieertragspotential der ersten Windenergieanlage zu bestimmen.

Alternativ bzw. zusätzlich kann gemäß einer Variante des Anspruchs 1 eine Energieertragsrangliste der Windenergieanlagen des Windenergieanlagenparks gebildet werden oder gebildet sein. Die Energieertragsrangliste betrifft den Energie- bzw. Leistungsertrag der jeweiligen Windenergieanlage im energieoptimierten Normalbetrieb, um einen entsprechenden Vergleich vorsehen zu können. Die Energieertragsrangliste kann insbesondere in Abhängigkeit verschiedener Windrichtungen und/oder verschiedener Windstärken als mehrdimensionale Matrix gebildet bzw. ausgemessen werden.

Durch Erstellen einer Energieertragsrangliste ist es besonders einfach möglich, ein Energieertragspotential der ersten Windenergieanlage zu bestimmen, beispielsweise dadurch, dass der Energieertrag einer oder wenigstens zwei zweiter Windenergieanlagen berücksichtigt wird, um das Energieertragspotential der ersten Windenergieanlage anzugeben. Hierzu werden gemäß einer Variante des Anspruchs 1 die wenigstens eine zweite Windenergieanlage oder die wenigstens zwei zweiten Windenergieanlagen in der Energieertragsrangliste berücksichtigt, die benachbart zu dem Energieertrag der ersten Windenergieanlage ist oder sind. Es können hierbei die unmittelbaren Nachbarn als auch noch weitere entfernt liegende Nachbarn berücksichtigt werden. Das Energieertragspotential der ersten Windenergieanlage kann dann beispielsweise auch einfach ein Mittelwert der Energieerträge der benachbarten zweiten Windenergieanlagen sein. In diesem Fall ist das Kriterium zur Auswahl der wenigstens zwei zweiten Windenergieanlagen, dass es sich hierbei um Energieertragsnachbarn zur ersten Windenergieanlage handelt. Es ist zu berücksichtigen, dass zur Bildung der Energieertragsrangliste vorzugsweise alle Windenergieanlagen des Windenergieanlagenparks nicht in einem reduzierten Energieertragsbetrieb geführt werden, sondern in einem energieoptimierten Normalbetrieb. Die Rangliste ist vorzugsweise in dem jeweiligen Betriebsführungssystem der Windenergieanlagen bzw. in einem übergeordneten Steuerungssystem für den Windenergieanlagenpark gespeichert.

Vorzugsweise ist, wie schon erwähnt, das Energieertragspotential der ersten Windenergieanlage von wenigstens einem Umgebungsparameter abhängig. Bei dem Umgebungsparameter kann es sich um die Windrichtung, die Windstärke, die Luftdichte, eine vorherrschende Turbulenz und/oder einen Windgradienten handeln.

Vorzugsweise werden für die Bestimmung des Energieertragspotentials der ersten Windenergieanlage ausschließlich zweite Windenergieanlagen verwendet, die in einem energieoptimierten Normalbetrieb betrieben werden.

Vorzugsweise ist als, insbesondere zusätzliches, Kriterium der Auswahl einer zweiten Windenergieanlage eine vergleichsweise geringe Standardabweichung einer ermittelten Wirkleistung der zweiten Windenergieanlage im Vergleich zu wenigstens einer weiteren zweiten Windenergieanlage vorgesehen. Die entsprechenden zweiten Windenergieanlagen, die eine zu große Standardabweichung im Energieertrag bzw. im Leistungsertrag aufweisen, werden zur Bestimmung des Energieertragspotentials der ersten Windenergieanlage ausgeschlossen, um entsprechend die Genauigkeit der Bestimmung des Energieertragspotentials der ersten Windenergieanlage zu erhöhen.

Vorzugsweise ist bzw. wird eine Matrix erstellt, die die Energieertragsrangliste in Abhängigkeit der Windrichtung angibt. Vorzugsweise ist bzw. wird eine Matrix erstellt, die die Energieertragsrangliste in Abhängigkeit eines weiteren Umgebungsparameters angibt. Die Matrix kann beispielsweise eine Energieertragsrangliste für verschiedene Windrichtungen in 5°-Abständen oder größeren oder kleineren Gradabständen aufweisen. Ferner kann die Matrix zusätzlich die Energieertragsrangliste in Abhängigkeit der Windstärken in Abständen von 1 m/s oder mehr oder weniger großen Abständen aufweisen. Zudem kann als weiterer Parameter in der Matrix die Luftdichte eingepflegt sein. Die sich so ergebenden gemessenen Werte werden dann entsprechend abgespeichert und können adaptiv und kontinuierlich, je nach herrschenden Umgebungsparametern, angepasst und optimiert werden. Vorzugsweise ergibt sich ein sich immer verbesserndes lernendes System, mit dem sehr genau ein Energieertragsverlust einer ersten Windenergieanlage anhand der vom Energieertrag her benachbarten Windenergieanlagen bestimmt bzw. errechnet werden kann.

Entsprechend kann auch bei Aufteilung des Windenergieanlagenparks in wenigstens zwei Gruppen von Windenergieanlagen die Gruppenaufteilung in Abhängigkeit von Umgebungsparametern, wie die Windrichtung, die Windstärke, die Lufttemperatur, den Windgradienten und/oder die Windturbulenzen und gegebenenfalls auch dem Luftdruck durchgeführt werden und das Ergebnis gespeichert werden, um so adaptiv und weiter verfeinernd ein möglichst genaues Ergebnis für das Energieertragspotential der ersten Windenergieanlage zu bestimmen bzw. zu berechnen.

Weitere Merkmale der Erfindung werden aus der Beschreibung erfindungsgemäßer Ausführungsformen zusammen mit den Ansprüchen und den beigefügten Zeichnungen ersichtlich. Erfindungsgemäße Ausführungsformen können einzelne Merkmale oder eine Kombination mehrerer Merkmale erfüllen.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:

Fig. 1    eine Draufsicht auf einen Windenergieanlagenpark mit 48 Windenergieanlagen bei einer bestimmten Windrichtung,

Fig. 2    den Windenergieanlagenpark aus Fig. 1 in schematischer Draufsicht bei einer anderen Windrichtung,

Fig. 3    einen weiteren Windenergieanlagenpark in schematischer Draufsicht mit 16 Windenergieanlagen,

Fig. 4    eine schematische Energieertragsliste des Windenergieanlagenparks aus Fig. 3 bei einer Windrichtung von 123°,

Fig. 5    eine schematische Energieertragsliste des Windenergieanlagenparks aus Fig. 3 bei einer Windrichtung von 340° und

Fig. 6    einen vereinfachten Verfahrensablauf zur Bildung einer Energieertragsrangliste von Windenergieanlagen eines Windenergieanlagenpa rks.

In den folgenden Figuren sind jeweils gleiche oder gleichartige Elemente bzw. entsprechende Teile mit denselben Bezugsziffern versehen, so dass von einer entsprechenden erneuten Vorstellung abgesehen wird.

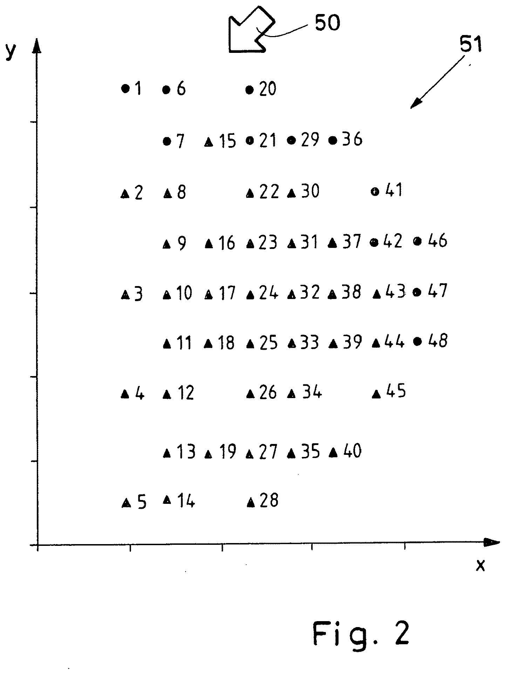

Die Figuren 1 und 2 zeigen schematisch eine Draufsicht auf einen Windenergieanlagenpark 51 mit 48 Windenergieanlagen. Es ist zudem in Fig. 1 und in Fig. 2 ein Wind 50 mit einer entsprechenden schematisch dargestellten Windrichtung gezeigt. Zu erkennen ist, dass die Windenergieanlagen, die mit einem ausgemalten schwarzen Punkt versehen sind und frei vom Wind 50 angeströmte Windenergieanlagen sind, und die mit einem grauen Dreieck versehen sind, gestört vom Wind angeströmte Windenergieanlagen sind. Im Fall der Fig. 1 bei einer Windrichtung von links in Fig. 1 gemäß dem Wind 50 sind die Windenergieanlagen 1, 2, 3, 4, 5, 7, 9, 11 und 13 frei angeströmt und die anderen Windenergieanlagen in den Wirbelschleppen der frei angeströmten und auch der weiteren Windenergieanlagen, also gestört vom Wind angeströmt. Entsprechend sind die Windenergieanlagen 1, 6, 7, 20, 21, 29, 36, 41, 42, 46, 47 und 48 in Fig. 2 bei der Windrichtung des Windes 50 der Fig. 2 frei angeströmt und die weiteren Windenergieanlagen gestört vom Wind angeströmt, d.h. durch weitere Windenergieanlagen gestört.

Damit wird der Windenergieanlagenpark 51 gemäß den Fig. 1 und 2 je nach Windrichtung in zwei unterschiedliche Gruppen von Windenergieanlagen unterteilt. Dieses sind Windenergieanlagen, die nicht durch andere Windenergieanlagen beeinflusst sind und solche, die durch andere Windenergieanlagen beeinflusst sind. Es wird erfindungsgemäß für jede Windrichtung, beispielsweise in Inkrementen von 1° oder kleineren oder größeren Inkrementen, berechnet, welche Windenergieanlagen zu welcher Gruppe gehören. Dieses kann in einem ersten Schritt nach der in IEC 6140012-1 angegebenen Formel

$$\alpha = 1,3 * arctan(2,5 * \frac{D_n}{L_n} + 0,15) + 10$$

sein, wobei $\alpha$ ein Winkel eines gestörten Sektors ist, $D_n$ der Rotordurchmesser von benachbarten Windenergieanlagen, die im Betrieb sind, $L_n$ der Abstand zwischen der zu bestimmenden Windenergieanlage und der benachbarten und im Betrieb befindlichen Windenergieanlage. Als zweiter Schritt wird eine Orientierung des gestörten Sektors wie folgt angegeben:

$$\beta = \begin{cases} 90 - \arctan\left(\dfrac{dy}{dx}\right) & f\ddot{u}r\ x_0 > x\ und\ y_0 > y \\[2mm] 90 + \arctan\left(\dfrac{dy}{dx}\right) & f\ddot{u}r\ x_0 > x\ und\ y_0 < y \\[2mm] 270 - \arctan\left(\dfrac{dy}{dx}\right) & f\ddot{u}r\ x_0 < x\ und\ y_0 < y \\[2mm] 270 + \arctan\left(\dfrac{dy}{dx}\right) & f\ddot{u}r\ x_0 < x\ und\ y_0 > y \end{cases}$$

$x_0$ ist die x-Koordinate der benachbarten und im Betrieb befindlichen Windturbine, $y_0$ ist die y-Koordinate der benachbarten und im Betrieb befindlichen Windenergieanlage, wobei die x- und y-Koordinaten in den Fig. 1 und 2 auch gezeigt sind. Hierbei ist die x-Koordinate die Abszisse und die y-Koordinate die Ordinate. Entsprechend sind x und y die x-Koordinate bzw. die y-Koordinate der Windenergieanlage, für die bestimmt werden soll, ob diese durch andere Windenergieanlagen gestört wird. dx ist der Abstand in der Abszisse zwischen der zu bestimmenden Windenergieanlage und der benachbarten und im Betrieb befindlichen Windenergieanlage und dy entsprechend der Ordinatenabstand diesbezüglich. $\beta$ ist der Winkel zwischen der zu bestimmenden Windenergieanlage und der benachbarten Windenergieanlage im Vergleich zur Nordausrichtung.

Schließlich wird über die folgende Formel

$$\gamma = |\beta - v_{dir}| - \frac{\alpha}{2}$$

bestimmt, ob die jeweilige Windenergieanlage zu den gestörten Windenergieanlagen gehört. Dieses ist dann der Fall, wenn $\gamma$ negativ ist. $\gamma$ ist insofern der Störungsindikationswinkel und $v_{dir}$ ist die Windrichtung. Diese Berechnungsschritte werden für alle Windenergieanlagen, die im Betrieb sind, durchgeführt. Nur die Windenergieanlagen, die immer ein positives $\gamma$ aufweisen, gehören zur ersten Gruppe von Windenergieanlagen, nämlich den Windenergieanlagen, die frei von Wind angeströmt werden. Alle anderen gehören zur zweiten Gruppe von Windenergieanlagen, die nicht frei angeströmt werden.

Um nun den Energieertragsausfall einer stillgesetzten bzw. mit reduziertem Energieertrag betriebenen Windenergieanlage zu bestimmen, wird beispielsweise in einem 10-Minuten-Mittelwert einer Windrichtung die entsprechende Gruppenaufteilung vorgenommen und der Ertragsausfall der nicht betriebsbereiten Windenergieanlage bzw. der Windenergieanlage, die in einem reduzierten Energieertragsbetrieb geführt wird, als Mittelwert des Energieertrags der weiteren Anlagen der dazugehörigen Gruppe angesetzt. Hierbei kann auch ein 10-minütiges Zeitintervall berücksichtigt werden. Für den Fall, dass beispielsweise die Windenergieanlage 2 bei einer Windrichtung gemäß Fig. 1 stillsteht, wird somit ein Mittelwert der Energieerträge der Windenergieanlagen 1, 3, 4, 5, 7, 9, 11 und 13 gebildet, und entsprechend ist dann der Mittelwert der Energieerträge bzw. der Wirkleistung dieser Windenergieanlagen über beispielsweise 10 Minuten das Energieertragspotential der Windenergieanlage 2. Für den Fall, dass die Windenergieanlage 2 nur mit einer 50%igen Leistung bzw. Energieertrag betrieben wird, wird die Differenz der möglichen Leistung zu der tatsächlich erzeugten Leistung berechnet. Entsprechend kann die im reduzierten Energieertragsbetrieb befindliche Windenergieanlage eine Windenergieanlage aus der Gruppe der gestörten vom Wind angeströmten Windenergieanlagen sein, so dass das Energieertragspotential dieser ersten Windenergieanlage beispielsweise durch einen Mittelwert der ermittelten Energieerträge der weiteren Windenergieanlagen aus dieser Gruppe gebildet wird.

Die Berechnung der Gruppen wird beispielsweise für jedes 10-Minuten-Zeitintervall auf das Grad genau ausgerechnet. Das erfindungsgemäße Verfahren führt auch bei komplexen Windenergieanlagenparks zu bemerkenswert guten Ergebnissen und kann auch durch eine größere Anzahl von Gruppen verfeinert werden. Beispielsweise kann eine Gruppe 3 vorgesehen sein, die Mehrfachstörungen vorsieht. Beispielsweise könnte bei der Ausführungsform gemäß Fig. 1 eine Gruppe 1 vorgesehen sein, die die Windenergieanlagen, die als Kreis dargestellt sind, vorsieht, eine Gruppe 2 der Windenergieanlagen 6, 8, 10, 12, 14, 15, 16, 18 und 19 und die Gruppe 3 die weiteren Windenergieanlagen. Unter Umständen kann dieses zu besseren und genaueren Ergebnissen führen. Dies muss allerdings nicht notwendigerweise so sein, da die komplexen Strömungsverhältnisse im Nachlauf von Windenergieanlagen bzw. Windrotoren auch zu entgegengesetzten Effekten führen können, was allerdings abhängig von der Windrichtung und des Designs des Windenergieanlagenparks 51 ist.

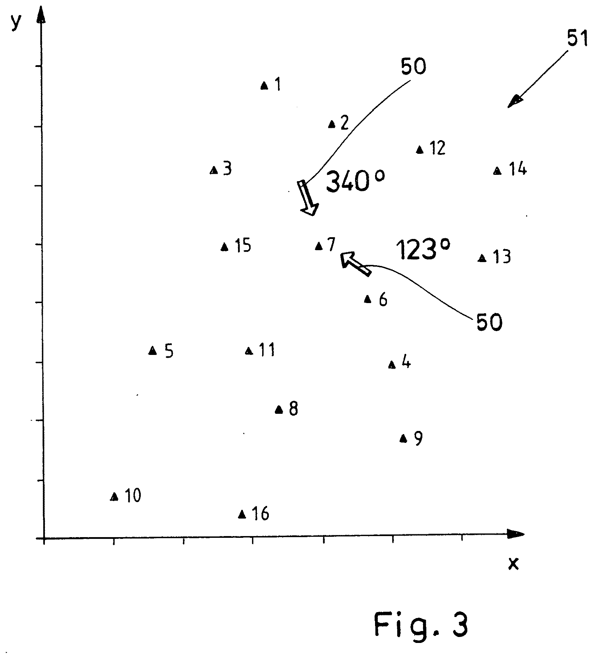

Fig. 3 zeigt schematisch einen weiteren Windenergieanlagenpark in einer schematischen Draufsicht mit einer dargestellten Abszisse x und einer Ordinate y. Es sind hier zwei Windpfeile 50 angezeigt, die in verschiedenen Winkeln, nämlich einem Winkel von 123° und einem Winkel von 340° jeweils relativ zur Windrichtung aus Norden angeordnet sind. Anhand des Windenergieanlagenparks 51 gemäß Fig. 3 soll das Erstellen einer Rangliste aller Windenergieanlagen im Windenergieanlagenpark in Abhängigkeit ihrer Leistung bzw. des Energieertrags und dieses wieder in Abhängigkeit der Windrichtung gezeigt werden. Diese Rangliste dient im Falle eines Ausfalls oder eines Reduzierens des Energieertrags einer Windenergieanlage dazu, mögliche Energiepartner zu bestimmen, aus dessen Mittelwert bzw. gewichteten Mittelwert bzw. durch Interpolation oder Extrapolation der Produktionsleistung die verlorene Energiemenge abgeleitet werden kann.

Bei der verlorenen Energiemenge handelt es sich um das Energieertragspotential einer stillgesetzten Windenergieanlage bzw. der Differenz des Energieertragspotentials zum reduzierten Energieertrag dieser Windenergieanlage, sofern diese mit reduziertem Energieertrag betrieben wird. Es werden somit nicht örtlich festgelegte Windenergieanlagen als Referenz herangezogen, also vom Ort her benachbarte Windenergieanlagen, sondern Windenergieanlagen, die in der Energieproduktion bei gegebenen Randbedingungen, d.h. gegebenen Umgebungsparametern, wie beispielsweise die Windrichtung oder die Windstärke, der nicht produzierenden Windenergieanlage bzw. der im reduzierten Energieertragsbetrieb geführten Windenergieanlage am nächsten sind. Diese Ausgestaltung der Erfindung hat den Vorteil, dass diese sehr genau ist.

Entsprechend kann die Rangliste auch zur Priorisierung von Wartungsarbeiten genutzt werden, da nur Anlagen mit weniger Ertrag bei einer entsprechend vorliegenden Windrichtung beispielsweise gewartet werden könnten.

Es wird für den Windenergieanlagenpark 51 aus Fig. 3 mit den 16 Windenergieanlagen je nach Windrichtung eine Energieertragsrangliste erstellt. Dieses kann einmalig geschehen und für entsprechende Windrichtungen und/oder Windstärken und/oder andere Umgebungsparameter kontinuierlich angepasst werden, so dass Veränderungen an den Windenergieanlagen, wie beispielsweise Software-Updates, Verschmutzungen von Rotorblättern, Veränderungen am Standort, wie beispielsweise das Fällen von großen Bäumen, die Energieertragsrangliste 52 entsprechend angepasst wird. Hierbei können die folgenden Daten gemessen bzw. bereitgestellt werden, wie die Windfahnenstellung, die vorzugsweise auch über alle Windfahnen jeder Windenergieanlage aus dem Windenergieanlagenpark 51 gemittelt zur Verfügung gestellt wird bzw. gemittelt abgelegt wird, die Gondelposition der jeweiligen Windenergieanlage, eine Wirkleistung bzw. einen Energieertrag der jeweiligen Windenergieanlage und einen Status der Windenergieanlage, ob diese beispielsweise in Ordnung oder nicht in Ordnung ist. Auch hier können Mittelwerte, beispielsweise ein 10-Minuten-Mittelwert, verwendet werden.

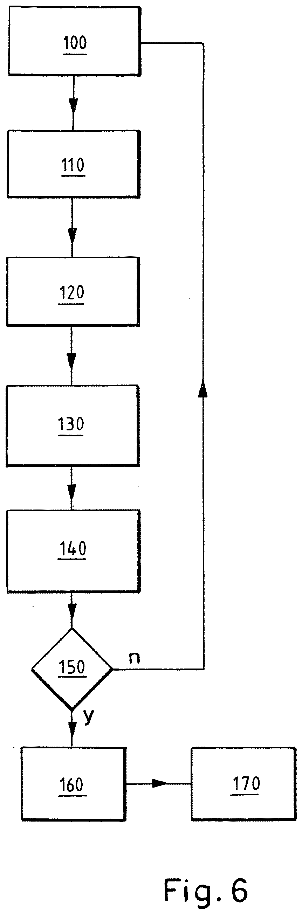

Ein Verfahren zur Bestimmung einer Energieertragsrangliste 52 ist beispielsweise in Fig. 6 schematisch dargestellt. Bei 100 wird geprüft, ob alle Windenergieanlagen 1 bis 16 Leistung produzieren bzw. einen Energieertrag liefern. Bei 110 wird der Mittelwert aller Windfahnenstellungen berechnet. Bei 120 wird die Wirkleistung jeder Windenergieanlage in einem 10-Minuten-Mittel gemessen, bei 130 wird die Wirkleistung jeder Windenergieanlage mit der größten Wirkleistung im Windenergieanlagenpark normiert. Bei der größten Wirkleistung im Windenergieanlagenpark ist eine Wirkleistung gemeint, die nicht über 10 Minuten gemittelt ist, sondern eine aktuell gemessene Wirkleistung ist. Es kann auch eine Wirkleistung über ein zeitliches Mittel vorgesehen werden und auch über ein 10-Minuten-Mittel. Die Normierung geschieht für jede Windenergieanlage im Windenergieanlagenpark. Bei 140 werden die Werte entsprechend in einem n-Tupel, wie beispielsweise einem 4-Tupel, also vierdimensional, in einer entsprechenden, insbesondere dynamischen, Matrix gespeichert, und zwar beispielsweise ein Tupel umfassend die Windrichtung, die Nummer der Windenergieanlage, die normierte Wirkleistung und die Anzahl der Messung, beispielsweise die n.-te Messung, wobei n eine ganze Zahl ist.

Bei 150 in Fig. 6 wird eine Abfrage gestellt, ob das Messverfahren n-Mal durchgeführt wurde. n ist vorgebbar und kann beispielsweise die Zahl 5 sein. n kann aber auch 10 oder 20 sein. Bei Beantwortung der Frage, dass dieses nicht der Fall ist (n), startet das Verfahren bei 100 erneut und wenn die Frage mit ja (y) beantwortet wird, wird bei 160 der Mittelwert jeder normierten Wirkleistung jeder Windenergieanlage gebildet und eine entsprechende Standardabweichung.

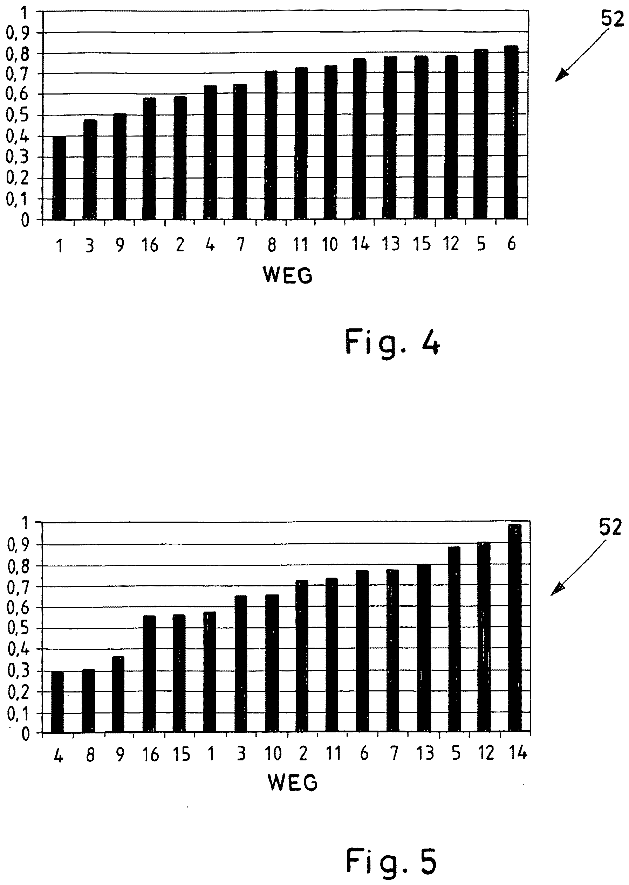

Bei 170 wird dann die Rangliste gebildet, die beispielsweise in den Fig. 4 und Fig. 5 dargestellt ist. Hier ist auf der Ordinate die normierte Wirkleistung aufgetragen und auf der Abszisse die Nummer der jeweiligen Windenergieanlage, wobei die Reihenfolge der Windenergieanlagen sich durch den Energie- bzw. Leistungsertrag ergibt. Hat eine Windenergieanlage eine zu große Standardabweichung der normierten Wirkleistungen für die n-Messungen, kann diese aus der Rangliste ausgeschlossen werden.

Bei der Rangliste 52 wird nach der Größe der normierten und gemittelten Wirkleistung sortiert. Die Standardabweichung spiegelt hierbei die Zuverlässigkeit der Reihenfolge wider. Sind die Standardabweichungswerte oberhalb eines Grenzwertes, ist die Streuung zu groß und es sollte alternativ die nächstbeste Referenzanlage bzw. benachbarte Windenergieanlage gewählt werden, wenn dort die Standardabweichung deutlich geringer ist.

Fig. 4 zeigt schematisch eine Energieertragsrangliste 52 bei einer Windrichtung von 123° und Fig. 5 schematisch eine Energieertragsrangliste 52 bei einer Windrichtung von 340°. Diese beiden Windrichtungen sind in Fig. 3 angedeutet. Bei dem Windenergieanlagenpark der Fig. 3 hat eine einjährige Auswertung der entsprechend gemessenen Daten die entsprechenden Energieertragsranglisten für die verschiedenen Windrichtungen ergeben. Als Beispiele sind die Fig. 4 und Fig. 5 gezeigt.

Fällt beispielsweise die Turbine 7 aus, können bei einer Windrichtung von 123° (vgl. Fig. 4) zur Bestimmung des Energieertragsausfalls bzw. des Energieertragspotentials die Energienachbarn 4 und 8 verwendet werden und gegebenenfalls auch noch 2 und 11. Die Energieerträge bzw. Wirkleistungen dieser dann produzierenden Windenergieanlagen können verwendet werden, um das Energieertragspotential der Windenergieanlage 7 zu bestimmen. Beispielsweise kann dieses durch Mittelwertbildung bzw. Interpolation oder gewichtete Mittelwertbildung geschehen. Bei der gewichteten Mittelwertbildung würde beispielsweise der Energieertrag der Windenergieanlagen 4 und 8 doppelt so stark bewertet werden wie der Energieertrag der Windenergieanlagen 2 und 11.

Bei einer Windrichtung von 340° (vgl. Fig. 5) sind die unmittelbaren Energienachbarn der Windenergieanlage 7 die Energieanlagen 6 und 13 und die entsprechend etwas weiter entfernten Energienachbarn die Windenergieanlagen 11 und 5. Entsprechend kann dann mittels des Energieertrags dieser Windenergieanlagen (11 und 5 sowie 6 und 13) das Energieertragspotential der Windenergieanlage 7 bestimmt werden. Damit können aus dem Mittelwert der Wirkleistungen zum aktuellen Stillstandszeitpunkt einer ersten Windenergieanlage die Energienachbarn herangezogen werden, um die Energiemenge zu bestimmen, die die Windenergieanlage 7 beispielsweise produziert hätte. Als Energienachbarn werden bevorzugt bis zu maximal 5 in eine Richtung benachbarte Windenergieanlagen verstanden.

Ein besonders vorteilhaftes Verfahren sieht weiterhin vor, dass zur Bestimmung der Energienachbarn zusätzlich geprüft wird, ob der Energienachbar in der Wirbelschleppe bzw. im Nachlauf der ersten Windenergieanlage (hier Anlage 7) liegt. Diese Überprüfung kann analog zu den Formeln erfolgen, die oben zur Bestimmung der Windenergieanlage der Gruppe 2 angegeben wurden. In dem Fall, dass der Energienachbar im unmittelbaren Nachlauf liegt, wird er zur Berechnung ausgeschlossen, da zu erwarten ist, dass sich der Energieertrag durch den Ausfall der ersten Windenergieanlage signifikant verändert. Der nächste Energienachbar wird dann, ggf. unter Berücksichtigung eines Gewichtungsfaktors, für das Verfahren herangezogen. Diese Ausführungsform erhöht die Verfahrensgenauigkeit für Windparks in ebenem Gelände erheblich. Bei Windparks in bergigem Gelände kann das Ergebnis aber auch ohne diese zusätzliche Überprüfung genauer sein.

Es kann auch eine Strategie zur Wartungspriorisierung abgeleitet werden. Geplante Stillstandszeiten, wie z.B. eine Jahreswartung oder ein Ölwechsel, könnten beispielsweise bei Wind aus 340° bevorzugt an Turbine 4 oder 8, und nicht bei Turbine 12 oder 14, durchgeführt werden.

Alle genannten Merkmale, auch die den Zeichnungen allein zu entnehmenden sowie auch einzelne Merkmale, die in Kombination mit anderen Merkmalen offenbart sind, werden allein und in Kombination als erfindungswesentlich angesehen. Erfindungsgemäße Ausführungsformen können durch einzelne Merkmale oder eine Kombination mehrerer Merkmale erfüllt sein.

Bezugszeichenliste

| | |
|---|---|
| 1-48 | Windenergieanlage |
| 50 | Wind |
| 51 | Windenergieanlagenpark |
| 52 | Energieertragsrangliste |
| 100 | Prüfung, ob alle Windenergieanlagen produzieren |
| 110 | Berechnung des Mittelwertes aller Windfahnenstellungen |
| 120 | Messung der Wirkleistung jeder Windenergieanlage im 10 Minutentakt |
| 130 | Normierung der Wirkleistung der Windenergieanlage mit der größten Leistung im Park |
| 140 | Speicherung der Werte in einer beispielsweise vierdimensionalen dynamischen Matrix (Windrichtung / Windenergieanlage / normierte Wirkleistung / n.-Messung) |
| 150 | Abfrage n-Mal durchgeführt |
| 160 | Bildung von Mittelwert und Standardabweichung |
| 170 | Bildung der Rangliste |

**Patentansprüche**

1. Verfahren zur Ermittlung eines Energieertragsverlustes einer ersten Windenergieanlage (1-49) aus einem Windenergieanlagenpark (51) mit mehreren Windenergieanlagen (1-49),

   wobei die erste Windenergieanlage (1-49) in einem reduzierten Energieertragsbetrieb geführt wird, der außerhalb eines energieoptimierten Normalbetriebs liegt,
   wobei ein reduzierter Energieertrag der ersten Windenergieanlage (1-49) ermittelt wird,
   wobei wenigstens eine in einem energieoptimierten Normalbetrieb betriebene zweite Windenergieanlage (1-49) nach einem vorgebbaren Kriterium ausgewählt wird oder ist,
   wobei der Energieertrag der wenigstens einen zweiten Windenergieanlage (1-49) ermittelt wird,
   wobei in Abhängigkeit des Energieertrages der wenigstens einen zweiten Windenergieanlage (1-49) ein Energieertragspotential der ersten Windenergieanlage (1-49) bestimmt wird und
   die Differenz des Energieertragspotentials der ersten Windenergieanlage (1-49) und des ermittelten reduzierten Energieertrags gebildet wird,
   wobei

   a) der Windenergieanlagenpark (51) in wenigstens eine erste Gruppe von Windenergieanlagen (1-49), die frei vom Wind (50) angeströmte Windenergieanlagen (1-49) umfasst, und eine zweite Gruppe von Windenergieanlagen (1-49), die gestört vom Wind (50) angeströmte Windenergieanlagen (1-49) umfasst, aufgeteilt wird oder ist und die erste Windenergieanlage (1-49) und die wenigstens eine zweite Windenergieanlage (1-49) aus der gleichen Gruppe stammen;
   b) eine Energieertragsrangliste (52) der Windenergieanlagen (1-49) des Windenergieanlagenparks (51) gebildet wird und die wenigstens eine zweite Windenergieanlage (1-49) in der Energieertragsrangliste (52) benachbart zu der ersten Windenergieanlage (1-49) ist; und/oder
   c) wenigstens zwei zweite Windenergieanlagen (1-49) ausgewählt werden oder sind, wobei der Energieertrag der wenigstens zwei zweiten Windenergieanlagen (1-49) ermittelt wird, wobei in Abhängigkeit der Energieerträge der wenigstens zwei zweiten Windenergieanlagen (1-49) ein Energieertragspotential der ersten Windenergieanlage (1-49) bestimmt wird, wobei zur Bestimmung des Energieertragspotentials der ersten Windenergieanlage (1-49) die Energieerträge der wenigstens zwei zweiten Windenergieanlagen (1-49) interpoliert oder extrapoliert werden.

2. Verfahren nach einem Anspruch 1, **dadurch gekennzeichnet, dass** das Verfahren automatisch, insbesondere vollautomatisch, durchgeführt wird.

3. Verfahren nach einem Ansprüche 1 bis 2, **dadurch gekennzeichnet, dass** das Führen der ersten Windenergieanlage (1-49) in dem reduzierten Energieertragsbetrieb ein Stillstand oder ein leistungsloser Betrieb der ersten Windenergieanlage (1-49) ist.

4. Verfahren nach einem der Ansprüche 1 bis 3, **dadurch gekennzeichnet, dass** das Energieertragspotential der ersten Windenergieanlage (1-49) von wenigstens einem Umgebungsparameter abhängt.

5. Verfahren nach einem der Ansprüche 1 bis 4, **dadurch gekennzeichnet, dass** für die Bestimmung des Energieertragspotentials der ersten Windenergieanlage (1-49) ausschließlich zweite Windenergieanlagen (1-49) verwendet werden, die in einem energieoptimierten Normalbetrieb betrieben werden.

6. Verfahren nach einem der Ansprüche 1 bis 5, **dadurch gekennzeichnet, dass** als, insbesondere zusätzliches, Kriterium der Auswahl einer zweiten Windenergieanlage (1-49) eine vergleichsweise geringe Standardabweichung einer ermittelten Wirkleistung der zweiten Windenergieanlage(1-49) im Vergleich zu wenigstens einer weiteren zweiten Windenergieanlage (1-49) ist.

**Claims**

1. A method of determining an energy yield loss of a first wind energy installation (1-49) of a wind farm (51) having a plurality of wind energy installations (1-49),

   wherein the first wind energy installation (1-49) is operated in a reduced energy yield mode of operation which lies outside an energy-optimized normal mode of operation,
wherein a reduced energy yield of the first wind energy installation (1-49) is determined,
wherein at least one second wind energy installation (1-49) which is operated in an energy-optimized normal mode of operation is selected or has been selected according to a specifiable criterion,
wherein the energy yield of the at least one second wind energy installation (1-49) is determined,
wherein an energy yield potential of the first wind energy installation (1-49) is determined as a function of the energy yield of the at least one second wind energy installation (1-49), and
the difference between the energy yield potential of the first wind energy installation (1-49) and the determined reduced energy yield is formed, wherein

a) the wind farm (51) is divided, or has been divided, into at least a first group of wind energy installations (1-49) which comprises wind energy installations (1-49) with freely inflowing wind (50), and a second group of wind energy installations (1-49) which comprises wind energy installations (1-49) with disrupted inflowing wind (50), and the first wind energy installation (1-49) and the at least one second wind energy installation (1-49) originate from the same group;
b) an energy yield ranking list (52) of the wind energy installations (1-49) of the wind farm (51) is formed and the at least one second wind energy installation (1-49) is adjacent to the first wind energy installation (1-49) in the energy yield ranking list (52); and/or
c) at least two second wind energy installations (1-49) are selected or have been selected, wherein the energy yield of the at least two second wind energy installations (1-49) is determined, wherein an energy yield potential of the first wind energy installation (1-49) is determined as a function of the energy yields of the at least two second wind energy installations (1-49),

wherein, in order to determine the energy yield potential of the first wind energy installation (1-49), the energy yields of the at least two second wind energy installations (1-49) are interpolated or extrapolated.

2. The method according to claim 1, **characterized in that** the method is carried out automatically, in particular fully automatically.

3. The method according to any one of the claims 1 to 2, **characterized in that** the operation of the first wind energy installation (1-49) in the reduced energy yield mode of operation is a standstill or a powerless mode of operation of the first wind energy installation (1-49).

4. The method according to any one of the claims 1 to 3, **characterized in that** the energy yield potential of the first wind energy installation (1-49) depends on at least one environmental parameter.

5. The method according to any one of the claims 1 to 4, **characterized in that**, for determining the energy yield potential of the first wind energy installation (1-49), only second wind energy installations (1-49) are used which are operated in an energy-optimized normal mode of operation.

6. The method according to any one of the claims 1 to 5, **characterized in that** a criterion, in particular an additional criterion, of the selection of a second wind energy installation (1-49) is a comparatively small standard deviation of a determined effective power of the second wind energy installation (1-49) in comparison with at least one further second wind energy installation (1-49).

**Revendications**

1. Procédé pour déterminer une perte de rendement énergétique d'une première éolienne (1-49) d'un parc éolien (51) comportant plusieurs éoliennes (1-49),

dans lequel la première éolienne (1-49) fonctionne en mode de rendement énergétique réduit situé en dehors d'un mode de fonctionnement éco-énergétique normal,
dans lequel un rendement énergétique réduit de la première éolienne (1-49) est déterminé,
dans lequel au moins une deuxième éolienne (1-49), fonctionnant en mode normal à pleine puissance, est sélectionnée selon un critère prédéfinissable,
dans lequel le rendement énergétique de l'au moins une deuxième éolienne (1-49) est déterminé,
dans lequel un rendement énergétique potentiel de la première éolienne (1-49) est déterminé en fonction du rendement énergétique de l'au moins une deuxième éolienne (1-49) et
la différence entre le rendement énergétique potentiel de la première éolienne (1-49) et le rendement énergétique réduit déterminé est calculée, dans lequel

a) le parc éolien (51) est divisé en au moins un premier groupe d'éoliennes (1-49) qui englobe des éoliennes (1-49) fonctionnant librement avec le vent (50), et un deuxième groupe d'éoliennes (1-49) qui englobe des éoliennes (1-49) ne fonctionnant pas librement avec le vent (50), et la première éolienne (1-49) et l'au moins une deuxième éolienne (1-49) proviennent du même groupe ;

b) une liste de classement (52) des rendements énergétiques des éoliennes (1-49) du parc éolien (51) est établie et l'au moins une deuxième éolienne (1-49) est voisine de la première éolienne (1-49) sur la liste de classement (52) des rendements énergétiques ; et/ou

c) on sélectionne au moins deux deuxièmes éoliennes (1-49), dans lequel on détermine le rendement énergétique des au moins deux deuxièmes éoliennes (1-49), un rendement énergétique potentiel de la première éolienne (1-49) étant déterminé en fonction des rendements énergétiques des au moins deux deuxièmes éoliennes (1-49),

dans lequel on interpole ou on extrapole les rendements énergétiques des au moins deux deuxièmes éoliennes (1-49) pour déterminer le rendement énergétique potentiel de la première éolienne (1-49).

2. Procédé selon la revendication 1, **caractérisé en ce que** le procédé est réalisé automatiquement, en particulier de façon entièrement automatique.

3. Procédé selon l'une quelconque des revendications 1 à 2, **caractérisé en ce que** le fonctionnement de la première éolienne (1-49) en mode de rendement énergétique réduit est un arrêt ou un fonctionnement sans puissance de la première éolienne (1-49).

4. Procédé selon l'une quelconque des revendications 1 à 3, **caractérisé en ce que** le rendement énergétique potentiel de la première éolienne (1-49) dépend d'au moins un paramètre environnant.

5. Procédé selon l'une quelconque des revendications 1 à 4, **caractérisé en ce que**, pour déterminer le rendement énergétique potentiel de la première éolienne (1-49), on utilise exclusivement des deuxièmes éoliennes (1-49) qui fonctionnent en mode normal à pleine puissance.

6. Procédé selon l'une quelconque des revendications 1 à 5, **caractérisé en ce que** le critère, en particulier supplémentaire, pour sélectionner une deuxième éolienne (1-49), est un écart type comparativement faible d'une puissance active déterminée de la deuxième éolienne (1-49) par rapport à au moins une autre deuxième éolienne (1-49).

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100115951 A1
- EP 2028368 A2
- EP 1944509 A1
- EP 0847496 B1